Europäisches Patentamt

European Patent Office

Office européen des brevets

(19)

(11) Veröffentlichungsnummer: **0 232 515 B1**

# EUROPÄISCHE PATENTSCHRIFT

(12)

(45) Veröffentlichungstag der Patentschrift: **22.04.92**

(21) Anmeldenummer: **86117236.9**

(22) Anmeldetag: **10.12.86**

(51) Int. Cl.5: **H01L 21/76**, H01L 21/20, H01L 21/203, H01L 21/268, H01L 21/263

(54) **Strukturierter Halbleiterkörper.**

(30) Priorität: **20.12.85 DE 3545242**

(43) Veröffentlichungstag der Anmeldung:
**19.08.87 Patentblatt 87/34**

(45) Bekanntmachung des Hinweises auf die
Patenterteilung:
**22.04.92 Patentblatt 92/17**

(84) Benannte Vertragsstaaten:
**DE FR GB**

(56) Entgegenhaltungen:
**FR-A- 2 517 121**
**US-A- 3 798 061**

**THIN SOLID FILMS, Band 106, Nr. 1/2, August 1983, Seiten 3-136, Elsevier Sequoia, NL; Y. OTA: "Silicon molecular beam epitaxy"**

**IBM TECHNICAL DISCLOSURE BULLETIN, Band 9, Nr. 8, Januar 1967, Seite 1050, New York, US; H. WIDMER: "Producing a layer in the form of a pattern on the surface of a body"**

(73) Patentinhaber: **Licentia Patent-Verwaltungs-GmbH**
**Theodor-Stern-Kai 1**
**W-6000 Frankturt/Main 70(DE)**

(72) Erfinder: **Kasper, Erich, Dr. rer. nat.**
**Osterholzweg 16**
**W-7914 Pfaffenhofen(DE)**

(74) Vertreter: **Amersbach, Werner, Dipl.-Ing. et al**
**Licentia Patent-Verwaltungs-GmbH Theodor-Stern-Kai 1**
**W-6000 Frankturt 70(DE)**

## Beschreibung

Die Erfindung betrifft ein Verfahren zur Herstellung strukturierter Halbleiterkörper nach dem Oberbegriff des Patentanspruchs 1.

Die Erfindung ist insbesondere anwendbar zur Herstellung von Transistoren und/oder integrierten Schaltkreisen (IC's) auf der Grundlage eines Silizium (Si)-Substrates.

In der am gleichen Anmeldetag eingereichten deutschen Patentanmeldung mit dem internen Aktenzeichen UL 85/155 ist eine beispielhaft gewählte bipolare Halbleiterstruktur beschrieben, die mit Hilfe von derzeit üblichen Verfahren, z.B. Maskierungsverfahren durch Lithographie, Oxidations-, Diffusions-, Implantations, Epitaxie- sowie Metallisierungsverfahren herstellbar ist.

Bei einem derart strukturierten Halbleiterkörper ist insbesondere der Sperrbereich, z.B. ein als sperrender pn-Übergang dotierter Halbleiterbereich, lediglich durch kostenungünstige Isolationsdiffusions- und/oder Isolationsoxidationsvorgänge herstellbar. Dabei soll der Sperrbereich einen unerwünschten Stromfluß vermeiden, z.B. zwischen den benachbarten Transistoren eines IC's.

Aus dem IBM, Technical Disclosure Bulletin, Vol. 9, No. 8, 1967, Seite 1050 ist ein Verfahren zur Herstellung einer $SiO_2$-Schicht auf einem Si-Substrat durch lokale Energieeinrichtung mit einem fokussierten Elektronenstrahl, Laser usw. bekannt.

In der europäischen Patentanmeldung EP-A-0 113 983 ist ein 3-Kammer-Vakuumsystem beschrieben, bestehend aus einer Plasma-Ätzkammer zur Strukturierung einer Oxidschicht, einer MBE-Kammer zum Aufwachsen der Halbleiterschichten und einer Kammer in der eine Schutzschicht hergestellt wird. Das zu strukturierende Halbleitersubstrat wird zwischen den einzelnen Kammern für den jeweiligen Verfahrensschritt hin- und herbewegt.

Der Erfindung liegt daher die Aufgabe zugrunde, ein gattungsgemäßes Verfahren anzugeben, bei dem insbesondere der Sperrbereich zuverlässig und kostengünstig hergestellt wird und eine zuverlässige sowie kostengünstige Herstellung von Transistoren sowie integrierten Schaltkreisen mit kleinen Strukturen möglicht ist insbesondere in einer Kleinserienfertigung.

Diese Aufgabe wird gelöst durch die im kennzeichnenden Teil des Patentanspruchs 1 angegebenen Merkmale. Vorteilhafte Ausgestaltungen und/oder Weiterbildungen sind den Unteransprüchen entnehmbar.

Ein erster Vorteil der Erfindung besteht darin, daß insbesondere bei der Herstellung von bipolaren Schaltkreisen die Maskierungs- sowie Kontaktierungsvorgänge in kostengünstiger Weise vereinfacht werden können und zumindest teilweise überflüssig sind bei der Herstellung der dotierten und/oder undotierten Halbleiterbereiche.

Ein zweiter Vorteil besteht darin, daß nacheinander hergestellte Schichten, z.B. in einer MBE-Kammer, strukturiert werden können ohne aus der Anlage genommen zu werden.

Die Erfindung beruht auf der nachfolgend erläuterten Anwendung der sogenannten differentiellen Epitaxie auf Sihaltigem Material, die z.B. aus der Zeitschrift Journal of the Electrochemical Society 132, Seite 2227 (1985), bekannt ist. Dabei wird in einer Ultrahochvakuumanlage (Vakuum kleiner $10^{-9}$ mbar) mit Hilfe des Silizium-Molekularstrahlepitaxieverfahrens (Si-MBE) eine Si-Schicht aufgewachsen auf einem Si-Substrat, auf dem einkristalline Si-Bereiche sowie Siliziumdioxid ($SiO_2$)-Bereiche benachbart sind. Durch Wahl der Temperatur des Si-Substrates sowie des Vakuums, z.B. Art sowie Partialdruck von Restgasen, ist es gleichzeitig möglich, auf den einkristallinen Si-Bereichen einkristallines Si-Material aufzuwachsen während auf den $SiO_2$-Bereichen polykristallines Si-Material abgeschieden wird, dessen spezifische Leitfähigkeit einige Größenordnungen kleiner ist als diejenige des einkristallinen Si-Materials. Es entsteht ein genau bestimmbarer Übergang zwischen polykristallinem und einkristallinem Si-Material. Es ist möglich, die Wachstumsbedingungen so zu wählen, daß polykristallines und einkristallines Si-Material mit gleicher Schichtdicke abgeschieden werden.

Diese Eigenschaften sind nutzbar zur Herstellung der im folgenden beispielhaft gewählten Halbleiterstruktur.

Auf einem derzeit üblichen p-dotieren Silizium (Si)-Substrat, z.B. einer Si-Scheibe mit einem Durchmesser von 75 mm, einer Dicke von 0,5 mm sowie einer (100)-Kristallorientierung, wird zunächst eine in der Halbleitertechnologie übliche $n^+$-dotierte vergrabene Halbleiterschicht ("buried layer") erzeugt, z.B. durch einen Diffusionsvorgang. Das Si-Substrat wird nun ganzflächig mit einer ungefähr 1nm dicken Siliziumdioxid ($SiO_2$)-Schicht überzogen. Die $SiO_2$-Schicht ist beispielsweise herstellbar durch Ätzen, z.B. mit einer in der Halbleitertechnologie derzeit üblichen sogenannten RGA-Ätze oder der sogenannten Shiraki-Ätze. Anschließend wird das derart oxidierte Si-Substrat in eine Silizium-Molekularstrahlepitaxie (SiMBE)-Anlage eingebracht zur später erläuterten Weiterbearbeitung.

Die Herstellung der 1nm dicken $SiO_2$-Schicht ist alternativ auch dadurch möglich, daß das dotierte und/oder undotierte Si-Substrat unmittelbar in die SiMBE-Anlage eingebracht wird und dort mit einem Sauerstoff ($O_2$)-haltigem Gas, z.B. reinem $O_2$ und/oder gasförmigem Wasser ($H_2O$), so lange beschossen wird bis die 1nm dicke $SiO_2$-Schicht

entstanden ist. Dabei ist es zweckmäßig, das Si-Substrat auf eine Temperatur von ungefähr 250°C aufzuheizen.

Die 1nm dicken SiO$_2$-Schicht wird nun durch eine räumlich begrenzte Energieeinwirkung strukturiert, z.B. gemäß einer herzstellendem integrierten Schaltung. Diese Strukturierung ist z.B. möglich durch gesteuertes Abrastern des Si-Substrates mit einem fokussierten Laser- oder Elektronen- oder Ionenstrahl. Diese Steuerung und/oder Regelung erfolgt zweckmäßigerweise mit Hilfe einer Daten- und/oder Rechenanlage, in welcher die zu erzeugende Schaltung gespeichert ist. Die 1nm dicke SiO$_2$-Schicht verdampft dabei räumlich selektiv bei einer mittleren Temperatur von ungefähr 800°C. Es entstehen also Si-Einkristall-Halbleiterbereiche, neben denen SiO$_2$-Bereiche vorhanden sind. Es ist dabei z.B. möäglich, streifenförmige Si- und/oder SiO$_2$-Strukturen herzustellen mit einer Breite von ungefähr 0,5 $\mu$m.

Auf das derart strukturierte Si-Substrat wird nun mit Hilfe der eingangs erwähnten differentiellen SiMBE ganzflächig Silizium abgeschieden. Dabei entsteht auf den einkristallinen Si-Halbleiterbereichen eine einkristalline Si-Schicht, während auf den SiO$_2$-Bereichen polykristallines Silizium abgeschieden wird. Dieses ist wegen seiner bereits erwähnten geringen elektrischen Leitfähigkeit hervorragend geeignet zum Herstellen von isolierenden Sperrbereichen zwischen den Halbleiterstrukturen.

Da das polykristalline Silizium eine spezifische elektrische Leitfähigkeit hat, die um einige Größenordnungen kleiner ist als diejenige der einkristallinen Si-Halbleiterbereiche, ist es überraschenderweise möglich, in kostengünstiger Weise passive elektrische Widerstände zu integrieren. Dazu wird beispielsweise während der n$^+$-Dotierung des Emitters in dem polykristallinen Silizium ein Widerstandbereich, so stark dotiert, daß dort eine nutzbare Leitfähigkeit von z.B. $10^2$(Ohm cm)$^{-1}$entsteht. Über die geometrischen Ausmaße (Länge, Breite, Dicke) ist dann ein gewünschter Widerstandswert von z.B. 10 kOhm einstellbar. Der Widerstandsbereich ist dann kontaktierbar durch metallische Leiterbahnen. Auf diese Weise ist in kostengünstiger Weise beispielsweise eine Kombination aus mehreren Transistoren und einem passiven Widerstandsnetzwerk als integriertes Bauelement herstellbar.

## Patentansprüche

1. Verfahren zur Herstellung eines strukturierten Halbleiterkörpers durch Aufwachsen einer oder mehrerer Schichten aus Silizium auf ein Siliziumsubstrat mittels differentieller Epitaxie in einer Hochvakuumkammer, wofür die Oberfläche des Siliziumsubstrats mit einer strukturierten Siliziumdioxidschicht versehen wird, dadurch gekennzeichnet, daß zur Erzeugung der strukturierten Siliziumdioxidschicht die ganzflächig auf dem Siliziumsubstrat vorliegende Siliziumdioxidschicht in einer MBE-Hochvakuumkammer durch fokussiertes Laserlicht oder durch einen fokussierten Elektronenstrahl oder durch einen fokussierten Ionenstrahl in Teilbereichen der Substratoberfläche bis auf das Substrat entfernt wird.

2. Verfahren nach Anspruch 1, dadurch gekennzeichnet, daß die Strukturierung nach Maßgabe eines herzustellenden Musters durch eine Rechenanlage gesteuert und/oder geregelt wird.

3. Verfahren nach einem der Ansprüche 1 oder 2, dadurch gekennzeichnet, daß die ganzflächige Siliziumdioxidschicht in der Hochvakuumkammer durch Beschuß des Siliziumsubstrats mit einem sauerstoffhaltigen Gas hergestellt wird.

4. Verfahren nach einem der Ansprüche 1 bis 3 dadurch gekennzeichnet, daß die Siliziumdioxidschicht mit einer Schichtdicke von ungefähr einem Nanometer erzeugt wird.

## Claims

1. Method for the manufacture of a structured semiconductor body by growing one or more layers of silicon on a silicon substrate by means of differential epitaxy in a high-vacuum chamber, for which the surface of the silicon substrate is provided with a structured silicon dioxide layer, characterised thereby, that for the production of the structured silicon dioxide layer the silicon dioxide layer present over the whole area of the silcon substrate is removed in partial regions of the substrate surface as far as the substrate in a molecular beam epitaxy high-vacuum chamber by focussed layer light or by a focussed electron beam or by a focussed ion beam.

2. Method according to claim 1, characterised thereby that the structuring is controlled and/or regulated by a computer in accordance with a pattern to be manufactured.

3. Method according to one of the claims 1 or 2, characterised thereby that the whole area silicon dioxide layer is manufactured in the high-vacuum chamber by bombardment of the silicon substrate with a gas containing oxygen.

4. Method according to one of the claims 1 to 3, characterised thereby that the silicon dioxide layer is produced with a layer thickness of approximately one nanometre.

## Revendications

1. Procédé de fabrication d'un corps semi-conducteur structuré par croissance d'une ou plusieurs couches de silicium sur un substrat de silicium par épitaxie différentielle dans une chambre à vide poussé, la surface du substrat de silicium étant munie à cet effet d'une couche de dioxyde de silicium structurée, caractérisé en ce que, pour produire la couche de dioxyde de silicium structurée, la couche de dioxyde de silicium présente sur toute la surface du substrat de silicium est éliminée dans des régions partielles de la surface du substrat jusqu'au substrat dans une chambre de MBE à vide poussé par une lumière laser focalisée ou par un faisceau électronique focalisé ou par un faisceau ionique focalisé.

2. Procédé selon la revendication 1, caractérisé en ce que la structuration est commandée et/ou réglée par un dispositif de calcul en fonction d'un motif à former.

3. Procédé selon l'une des revendications 1 ou 2, caractérisé en ce que la couche de dioxyde de silicium qui s'étend sur toute la surface est fabriquée dans la chambre à vide poussé par bombardement du substrat de silicium avec un gaz contenant de l'oxygène.

4. Procédé selon l'une des revendications 1 à 3, caractérisé en ce que la couche de dioxyde de silicium est produite avec une épaisseur de couche d'environ 1 nm.